Europäisches Patentamt

European Patent Office

Office européen des brevets

(19)

(11) **EP 0 994 361 A2**

(12) **EUROPEAN PATENT APPLICATION**

(43) Date of publication:
**19.04.2000  Bulletin 2000/16**

(51) Int. Cl.[7]: **G01R 31/3185**

(21) Application number: **99117109.1**

(22) Date of filing: **28.08.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **02.10.1998 DE 19845409**

(71) Applicant:
**International Business Machines Corporation
Armonk, NY 10504 (US)**

(72) Inventors:
• **Appinger, Jörg
71134 Aidlingen 2 (DE)**

• **Neuhäusler, Franz
89264 Bubenhausen (DE)**
• **Rost, Peter
73365 Calw (DE)**
• **Torreiter, Otto
70771 Leinfelden-Echterdingen (DE)**

(74) Representative:
**Teufel, Fritz, Dipl.-Phys.
IBM Deutschland Informationssysteme GmbH,
Patentwesen und Urheberrecht
70548 Stuttgart (DE)**

(54) **Fast calculaton of the flush delay on chips with LSSD design**

(57)    A new-style method of measuring the flush delay on chips in LSSD design is described. The flush delay is a measurement variable for the switching speed of a chip.

First the clock inputs of all flip-flops of a scan path are activated in order to switch the flip-flops to continuity. Then a signal edge is applied to the scan input which appears with a time delay at the scan output of the flip-flop chain. From the time at which the signal edge is applied to the scan input, the scan output is scanned at periodic intervals. The measurements obtained are compared against a pre-set expected value; all measurement values deviating from the expected value are counted. The flush delay is produced by multiplying the number of deviating measurement values by the measurement period.

In contrast to previous measurement methods, in the method presented here a single measurement is sufficient to determine the flush delay. It is also possible to measure the flush delays of several scan paths in parallel.

EP 0 994 361 A2

**Description**

Technical background

The invention relates to an improved method of measuring the flush delay, a characteristic variable for the speed of chips, and a test device for performing the flush delay measurement in accordance with the invention.

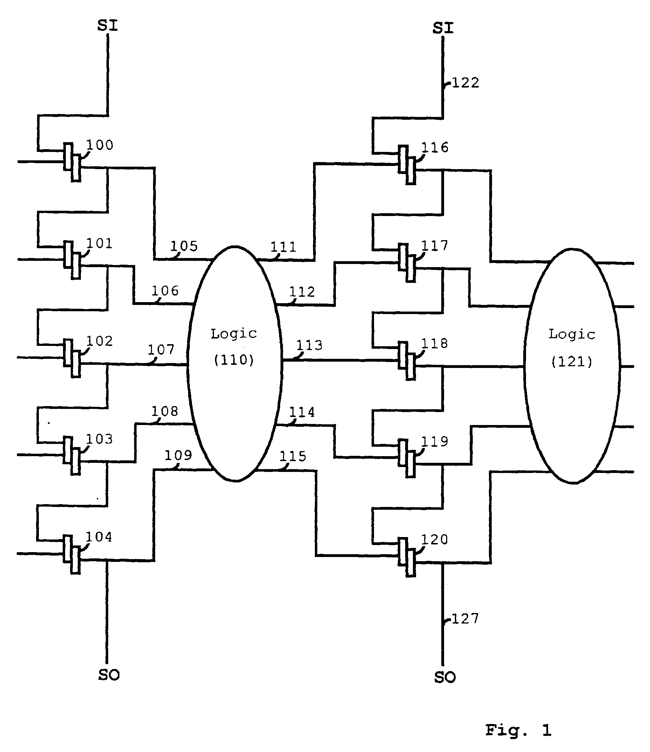

The invention is applicable to all chips constructed on the basis of the Level Sensitive Scan Design (LSSD). On chips of this kind the overall logic is subdivided into smaller logic sub-units. The input and output signals of the sub-units are buffered in flip-flops, which can be set and scanned for checking purposes via dedicated scan data paths. A more detailed description of Level Sensitive Scan Design is given in connection with Fig. 1.

Each scan path consists of a large number of in-series flip-flops, with the output of each flip-flop connected to the scan input of the next flip-flop. By way of the static clock inputs of the flip-flops it is possible to switch all flip-flops of a scan path to "flush" for measurement purposes. In this mode an edge applied to the input of a scan path appears - with a certain delay - at its output. This delay, the so-called flush delay, depends fundamentally on the switching speed of the flip-flops in the scan path, and is thus a measurement variable for the performance of a chip.

In the methods applied to date to calculate the flush delay, at a start time T0 an edge is applied to the input of the scan path. After a pre-set interval t the output of the scan path is scanned, and it is ascertained whether the measurement was made before or after the appearance of the edge. If the edge appeared before the measurement, t is shortened for the next measurement.

Various algorithms exist to define t for the subsequent measurement: In the so-called "global search" t is initially ,set very long, then halved, in order to determine whether the. transition occurs in the first or second half of t. The next value of t is set in the middle of the remaining time window, in order to determine whether the edge has already appeared at the output at the point in time or not. As a result the time window can be halved again. In this way it is possible to define the flush delay precisely by (n+1) measurements down to t OVER (2 SUP n).

In the so-called "linear search", on the other hand, t is incremented or decremented as appropriate in equal time steps, in order to determine the point in time at which the edge appears at the output of the scan path.

Both methods have in common the fact that, to determine the flush delay to a specified accuracy, a whole series of measurements must be taken. This results, firstly, in the disadvantage of long measuring times and, secondly, in high cost. The large number of measurements also leads to a certain warming of the chip, so that the temperature is not constant over the overall measurement. This corrupts the measurement result.

Object of the invention

The object of the invention is to deliver a method and a tester device to measure the flush delay on LSSD design chips which avoids the disadvantages of the previously applied measurement methods.

The object of the invention in particular is to deliver a method and a tester device to measure the flush delay on LSSD design chips which permits faster definition of the flush delay and also enables parallel measurement of several chains.

Solution delivered by the invention

The object of the invention is fulfilled by a method in accordance with Claims 1 and 5 and by a tester device in accordance with Claim 9.

In the solution delivered by the invention a signal edge is applied to the scan input which appears with a time delay at the scan output of the flip-flop chain. From the time at which the signal edge is applied to the scan input, the scan output is scanned at periodic intervals. The measurements obtained are compared against a pre-set expected value; all measurement values deviating from the expected value are counted. The flush delay is produced by multiplying the number of deviating measurement values by the measurement period.

In contrast to previous measurement methods, in the method presented here a single measurement is sufficient to determine the flush delay. This results in a significant speeding-up of the chip test, and thus means that significantly more measurements per time unit can be taken.

Due to the fact that the present method is able to determine the flush delay with a single measurement, the thermal load on the chip is also reduced. Whereas in previous measurement methods the increasing warming of the chip led to corruption of the measurement result, the thermal load in the present measurement method is negligible.

A further advantage is that the method can be implemented on currently available testers. Such testers are already equipped for the "global search" and "linear search" test methods. They can be converted to the method as presented by the invention at low cost, and the conversion cost is soon amortized.

In the method of measuring the flush delay of several chains of flip-flops in accordance with Claim 5, the outputs of several scan paths are scanned in parallel. The advantage of this simultaneous measurement is that the time required to measure a chip is further reduced. Because of the increasing integration density, both the number and the average length of the scan paths is increasing front chip generation to chip generation. Consequently the time saving is an increasingly important factor: while on a PU clock chip of the last generation with five flip-. flop chains there was a time saving by the factor 15, the same factor on the latest MBA chip is around 60. As a result, the use of the measurement method as presented by the invention has already brought about substantial cost savings.

Summary of drawings

Fig. 1    shows the data paths in a chip designed according to LSSD rules. Between the logical processing levels master/slave flip-flops are provided to store the interim results which can be set and scanned for test purposes.

Fig. 2    shows a master/slave flip-flop as is used in the LSSD design. As well as the data input used in the normal system mode, the master level also has a separate data input for the scan mode.

Fig. 3    illustrates the correlation between data input, clock and data output on a single flip-flop.

Fig. 4A    shows the mode of functioning of a master/slave flip-flop in system mode.

Fig. 4B    shows the mode of functioning of a master/slave flip-flop in scan mode. .

Fig. 5    shows the measurement setup to determine the flush. delay (0).

Fig. 6    illustrates the correlation between switching speed and geometry in a field-effect transistor. .

Fig. 7    shows the chip yield in the manufacturing process as a function of the switching speed of the chips. A Gaussian distribution is typically produced.

Fig. 8    shows the calculation of the flush delay in accordance with the invention. In the process, the scan output is scanned at regular time intervals and compared against a preset expected value.

Fig. 9    shows the parallel calculation of the respective flush-0 delay of three different scan paths.

Fig. 10    presents a method by which the accuracy in measuring the flush delay can be increased.

Description of illustrations

Fig. 1 gives an overview of a chip designed according to LSSD (Level Sensitive Scan Design) rules. In this design signal data are buffered in a series of master/slave flip-flops before being passed on to the next logic processing level. Thus, the input data for the logic processing level 110 are stored in flip-flops 100 to 104 by insertion. From there they pass over the signal lines 105 to 109 to the processing logic 110. The (interim) results produced by this logic must then in turn be stored. To this end, the results of logic 110 pass over the signal lines 111 to 115 to flip-flops 116 to 120. There these data serve in turn as the input data of the next logic level 121. The respective logic levels are designed such that the signal processing occurring on them takes less than one chip clock pulse. This delivers a defined data flow in the chip: within one system clock pulse data pass from the input flip-flops (for example 100-104) via the following processing level (here 110) to the next buffer flip-flops (here 116-120). Within the next system clock pulse these data then pass through the next logic level (here 121), are again caught in a series of flip flops, and so on. In this way a structured data flow through the chip is created.

A further advantage of this LSSD design is that the buffered results of each processing level can be simply scanned and checked for errors. To this end, each master/slave flip-flop has a second data input which, however, is deactivated in normal system mode. By means of these separate data inputs the various flip-flops of a processing level are now interconnected. This produces the so-called scan path, which is used to set and read the respective register values. One of the scan paths shown in Fig. 1 comprises the flip-flops 116 to 120 and the line connections 122 to 127. The Scan-In line 122 leads to the scan input of the first flip-flop 116. Its output is (123) linked to the scan input of the next flip-flop 117, of which the output is in turn (124) connected to the scan input of the next flip-flop 118, and so on. The output 127 of the last flip-flop 120 is at the same time the Scan-Out line of the overall scan path. By this "threading" of the flip-flops a shift register covering a large number of flip-flops is created with a common Scan-In 122 and a common Scan-Out 127. In Fig. 1 a second scan path is formed by the flip-flops 100 to 104. Each scan path permits the register contents of the flip-flops belonging to the scan path to be scanned via its Scan-Out line.

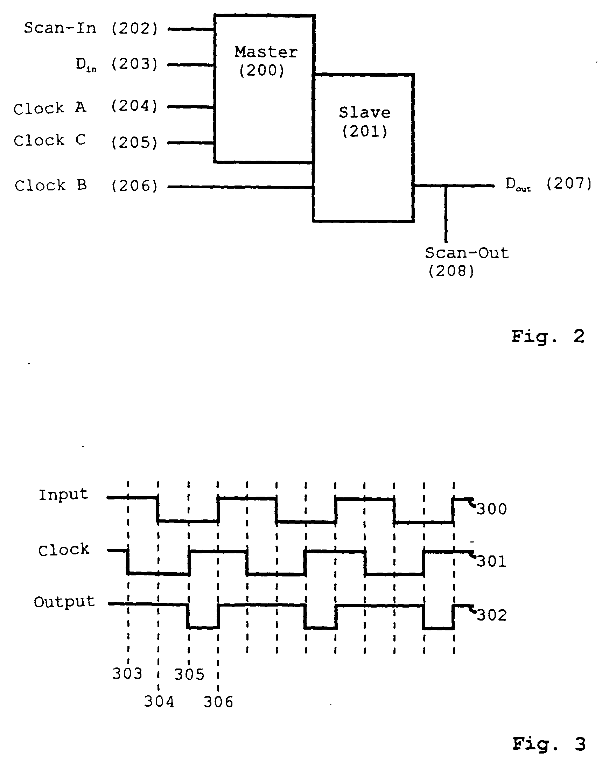

Fig. 2 shows the structure of the clock and data inputs of a master/slave flip-flop as is used in the LSSD design. The master level 200 has two clock inputs A (204) and C (205). Further inputs of the master level are the data input $D_{in}$ (203) and the Scan-In input SI (202). The data input $D_{in}$ (203) is the data input used in normal system mode. It is clocked by Clock C (205). The Scan-In input 202, on the other hand, is used only in scan mode; it is assigned the clock A (204). The slave level 201 has its own clock input B (206) by which the transfer of data from the master level is clocked. The slave level has only one output, which is both the data output $D_{out}$ for the regular system mode and the Scan-Out output SO (208) for the scan mode.

Each input of the master level is thus assigned its own clock input: clock C (205) controls the input $D_{in}$ (203) and clock A (204) controls the Scan-In input 202. This means that the input signal applied to the respective input can only be accepted when and for as long as the associated clock input is at "HIGH" potential. If the associated clock input is at "LOW", the applied signal is ignored.

Fig. 3 shows how the signal 302 at the output of a level depends both on the input signal 300 applied to the level and on the associated clock 301. Initially both the input signal and the clock are set to "HIGH", and so the output too is at "HIGH". Between the time 303 and the time 305 the clock input is at "LOW", and so no data are accepted by the input during that period. In this case the potential adopted at the time 303 remains stable at the output until a potential is again switched through from the input. The output therefore remains at "HIGH" until the time 305. Although the input potential changes to "LOW" at the time 304, since at that point the clock is at "LOW" the change cannot be switched through to the output. Only at time 305, when the clock is again "HIGH", does the "LOW" potential of input 300 appear at output 302. At the time 306, at which the input potential jumps to "HIGH", the clock input is still set to "HIGH". Therefore this change becomes directly visible at output 302. The flip-flop is thus transparent with an active clock input; the input data propagate through.

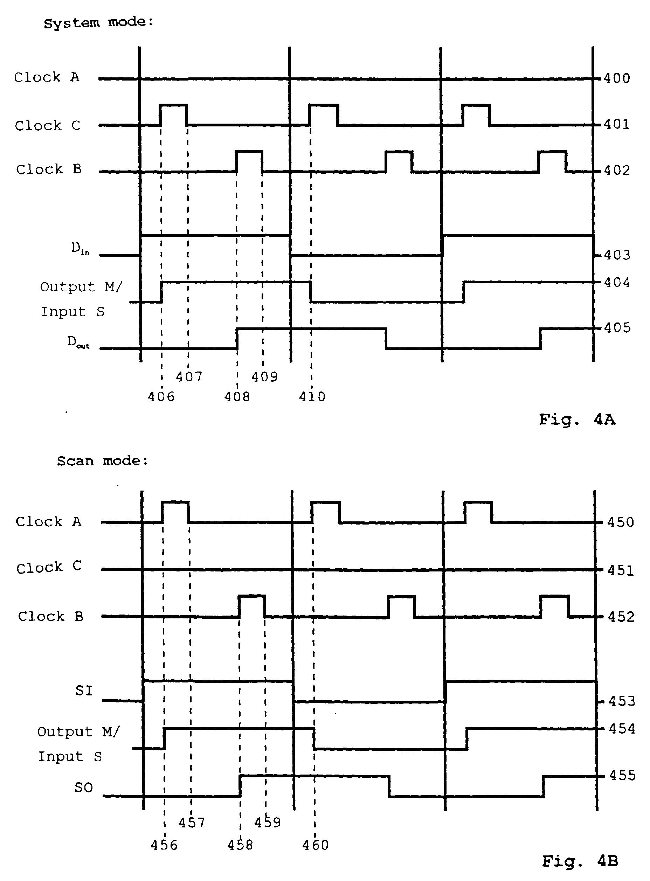

Fig. 4A describes a master/slave flip-flop operated in system mode. Clock A (400) is permanently set to "LOW", and so no data can be passed from the Scan-In input (202 in Fig. 2) to the output. The scan input is thus muted. Clock signals are applied both to the clock C input of the master level - which belongs to the data input $D_{in}$ - and to the clock B input of the slave level. Clock C (401) is phase-shifted in relation to clock B (402), wherein the C clock 401 is running half a clock cycle ahead of the B clock 402. At the data input $D_{in}$ (203 in Fig. 2) the input signal 403 is then applied. When the clock C rises to "HIGH" at the time 406 the input signal $D_{in}$ (403) can be switched through to the output of the master level (404). When the clock signal C jumps back to "LOW" at the time 407, the "HIGH" potential nevertheless remains at the output of the master level. The output of the master level (404) of the flip-flop is at the same time the input of the slave level. This signal 404 can only be switched through to the output $D_{out}$(405) of the overall flip-flop when the B clock (402) is active. The clock B signal 402 switches to "HIGH" at the time 408. At that point in time the output of the master level (404) is already at "HIGH". Therefore the output signal $D_{out}$ (405) switches from "LOW" to "HIGH" at the time 408. The output also remains set to that potential after the clock B signal has fallen back to "LOW".

Fig. 4B shows how the same master/slave flip-flop can be operated in scan mode. In this operating mode the clock C (451) is permanently set to "LOW", and so the data input $D_{in}$ (203 in Fig. 2) linked to the clock C is deactivated. The master level is supplied via the clock input A, and the slave level via the clock input B, with mutually phase-shifted clock pulses (450, 452). Clock A (450) is half a clock cycle ahead of clock B (452). At the Scan-In input SI (202 in Fig. 2) the signal 453 is then applied. As soon as the clock A jumps to "HIGH", which occurs at the time 456, the "HIGH" signal at the Scan-In input can be switched through to the output of the master level (signal 454). At the time 457 the clock A signal 450 switches from "HIGH" to "LOW". At the output of the master level 454 the last applied input signal - that is, "HIGH" - is retained. The output of the master level can, however, not yet be switched through to the output of the slave level 455, because the clock B signal (452) is still set to "LOW". Only at the time 458 does the clock B signal 452 jump from "LOW" to "HIGH", and the "HIGH" signal 454 at the output of the master level is switched through to the output 455 of the overall flip-flop.

Based on the mode of functioning of a master/slave flip-flop used in the LSSD design as presented thus far, the following presents the method in accordance with the invention for measurement of the so-called flush delay. The flush delay obtained in this way serves to characterize the processing speed of the chip.

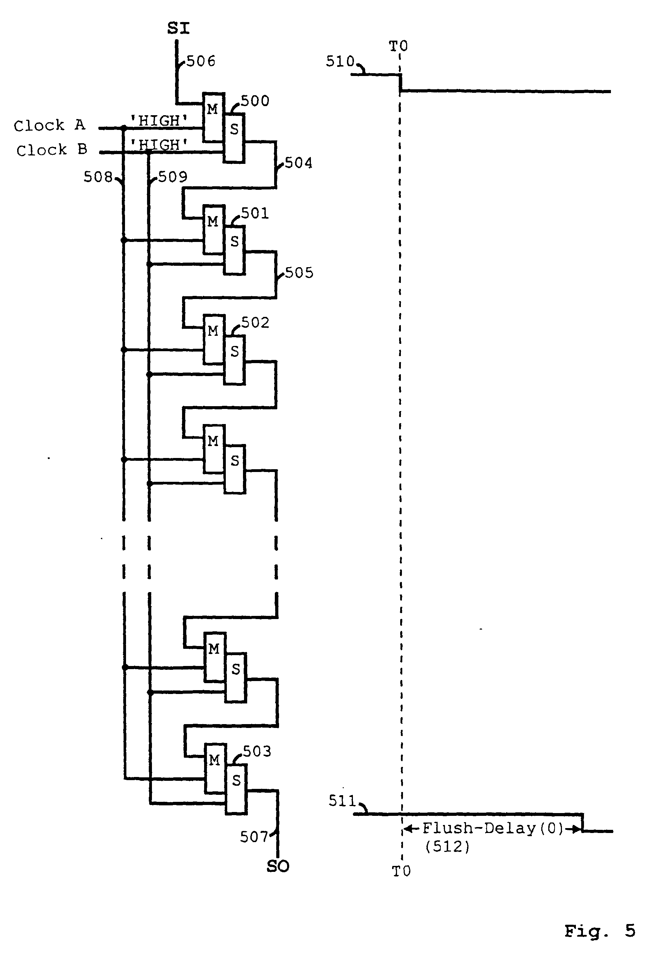

The measurement setup to determine the flush delay is shown in Fig. 5. The starting point is a scan path in a chip designed according to the rules of the LSSD design. The scan path comprises a series of master/slave flip-flops (500, 501, 502, ... 503) of which the scan outputs (208 in Fig. 2) are in each case connected to the scan inputs (202 in Fig. 2) of the next flip-flops (504, 505) . The scan input 506 of the first flip-flop 500 is thus also the scan input of the overall flip-flop chain, and the scan output 507 of the last flip-flop 503 in the scan path is thus also the scan output of the overall scan path.

However, the flip-flops are then not operated in the scan mode described with the aid of Fig. 4B. Instead, a constant "HIGH" potential is applied (508, 509) to both the clock A input of each master level and to the clock B input of each slave level. The consequence of this is that a signal applied to the scan input of a flip-flop appears immediately at the output of the flip-flop, but delayed by the switching speed of the flip-flop. As this output is at the same time the input of the next flip-flop in the scan path, and that flip-flop too is switched to "flush", the signal also appears at its scan output - again delayed by the switching speed. This flip-flop operating mode, in which both clock A and clock B are kept constant at "HIGH" potential, is termed "flush mode".

At the scan input 506 of the scan path a measurement signal 510 is then applied which, at the time T0, after an initialization phase, switches from "HIGH" to "LOW". This signal edge passes through the scan path, at the scan output of which the signal characteristic 511 is measured. On the measured signal 511 the "HIGH" to "LOW" edge is not at the time T0, but is time-shifted by a certain delay. This delay is the "flush delay(0)" (512). While the "flush delay(0)" designates the delay on a "HIGH" to "LOW" edge, the reverse case - a "LOW" to "HIGH" edge - is designated "flush delay(1)".

The flush delay is produced from the sum of the switching delays of the flip-flops in the scan path. A scan path comprises between 100 and over 100,000 flip-flops. While the switching delay produced by one flip-flop is so small that it could only be measured with a great deal of effort, the sum of all delays in a scan path can be comfortably measured. The flush delay obtained in this way permits conclusions to be drawn as to the average switching speed of a master/slave flip-flop. However, this switching speed depends in turn, on the switching speed of the field-effect transistors (FETs) on the chip. Thus the flush delay is not only a characteristic variable relevant to the flip-flops, but also generally to the processing speed ("performance") of the chip.

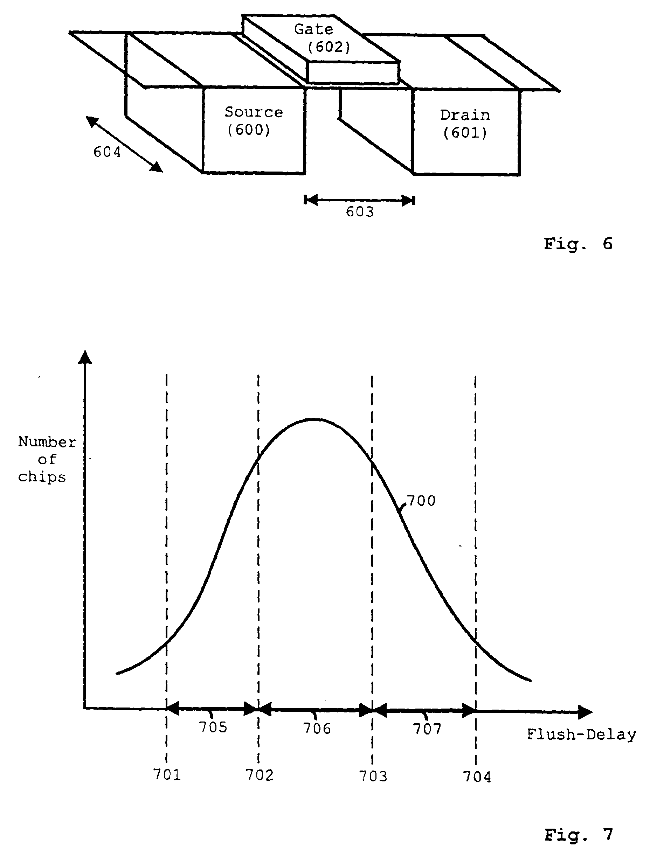

Fig. 6 shows the geometry of a field-effect transistor. The current flow between the source (600) and drain (601) is determined by the voltage applied to the gate (602). In a n-FET the gate must be positively charged in order to permit a current flow between source and drain; otherwise the source-drain path is blocked. The currents flowing over the source-drain path primarily serve to charge and reverse-charge the gates of other field-effect transistors. However, this means that the switching speed of the FETs depends on the current rating which is able to flow on the conductive source-drain path. This current rating is determined by the impedance of the source-drain path, and so depends both on the channel length 603 and on the width 604 of the FET. The shorter the channel, the higher is the flowing current, and the shorter will be the switching time.

Dictated by the manufacturing process, there are variations in the channel lengths of FETs resulting, for example, from changed exposure conditions in photolithographic manufacturing steps or from the reduction in activity of etching solutions, etc. Consequently, the switching speeds of the FETs too are subject to certain manufacturing tolerances. The flush delay measurement provides a simple and fast means of assessing the switching speed of a chip. A particular advantage of the method is that the flush delay of an entire scan path - that is, a chain of flip-flops - is measured at once, because the flush delay thus depends on the response of a large number of FETs, and as such provides an averaged performance figure. In particular, the various FETs of a scan path are distributed over the entire chip, so that the flush delay also provides an average value in spatial terms. It can frequently be observed that the switching speed of the FETs on a chip is subject to a gradient; that is to say, for example, that FETs on the left side of the chip switch faster than identically dimensioned FETs on the right. Inhomogeneities and gradients of this kind are caused in particular by mask and exposure steps. For this reason especially, it is important that a performance measurement of a chip incorporates the characteristics of various FETs from various chip regions, and in the flush delay measurement described this is the case.

Fig. 7 shows a typical curve (700) for the dependency of the chip yield on the measured flush delay. The flush delay goes to the right and the number of chips with that delay goes upward. An approximate Gaussian distribution around the expected flush delay value is produced. By means of so-called sort points (701, 702, 703, 704) ranges with different chip performance can then be defined. For example, the sort points 701 and 702 define a range (705) of above-averagely fast chips which can be deployed in high-end machines with high clock speeds. The sort points 702 and 703 define the normal range 706 of performance, while the chips in range 707 are particularly slow.

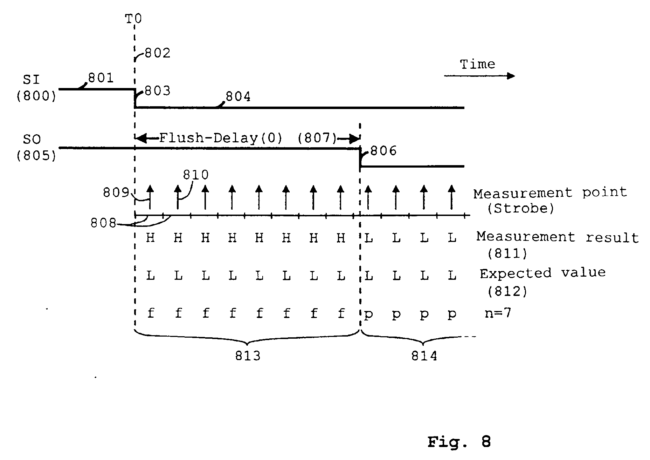

Fig. 8 shows the execution of the measurement method in accordance with the invention. For the purpose, the input signal is applied to the scan input 800 of the scan path. The time characteristic of the signal is plotted from left to right. In the range 801 of the signal characteristic the scan path is initialized with "HIGH" potential. Then, at the time T0 (802), the potential falls in the edge 803 to "LOW" (804). This signal edge then propagates along the scan path and appears after a delay at the scan output 805. The time gap between the time T0 (802) and the occurrence (806) of the edge at the scan output defines the flush delay(0) (807). In the present case of a "HIGH" to "LOW" edge the term used is "flush delay(0)", because the edge is to potential 0. In the reverse case, flush delay(1), there is a transition to potential 1 - that is, a "LOW" to "HIGH" edge.

To measure the flush delay, as from the time T0 (802) the scan output (805) is scanned once per measurement interval $\Delta T$ (808). The measurements are taken in the middle of the respective measurement interval. Each measurement point (strobe) is shown in Fig. 8 as an arrow (809, 810). The first measurement (809) thus occurs 0.5 x $\Delta T$ after T0, the second measurement (810) 1.5 x $\Delta T$ after T0, etc.

In measurement of the signal arriving at the scan output 805 the following result (811) is obtained: The first eight read pulses deliver a "HIGH" potential, then the edge 806 appears at the scan output and so the ninth and subsequent read pulses deliver a "LOW" potential. The measurement result obtained in this way is then compared against a pre-defined expected value (812). In the present case the expected value is defined as the potential applied to the scan output after the edge occurs. The "LOW" potential is thus defined as the expected value. The comparison of the measurement result 811 with the expected value 812 produces no match for the first eight measurements ("fail", 813). For the ninth and subsequent measurements there is a match ("pass", 814). A counting device, which may be executed as hardware or software, counts the measurement results which do not match the expected value - that is to say, the "fails" (813). In the case of Fig. 8 the total n, the number of "fails", is 8. Together with the measurement interval $\Delta T$ the flush delay can be calculated from it:

$$\text{Flush delay} = n \times \Delta T$$

The shorter the selected read-out period, the more precisely can the flush delay be calculated.

An advantage of the measurement method as presented by the invention is that only one single measurement is required to calculate the flush delay, regardless of whether a long or short flip-flop chain is being measured. The previously familiar measurement methods required a large number of measurements. This was time-consuming and also meant that the chip warmed up in the course of measuring, which in turn corrupted the measurement result.

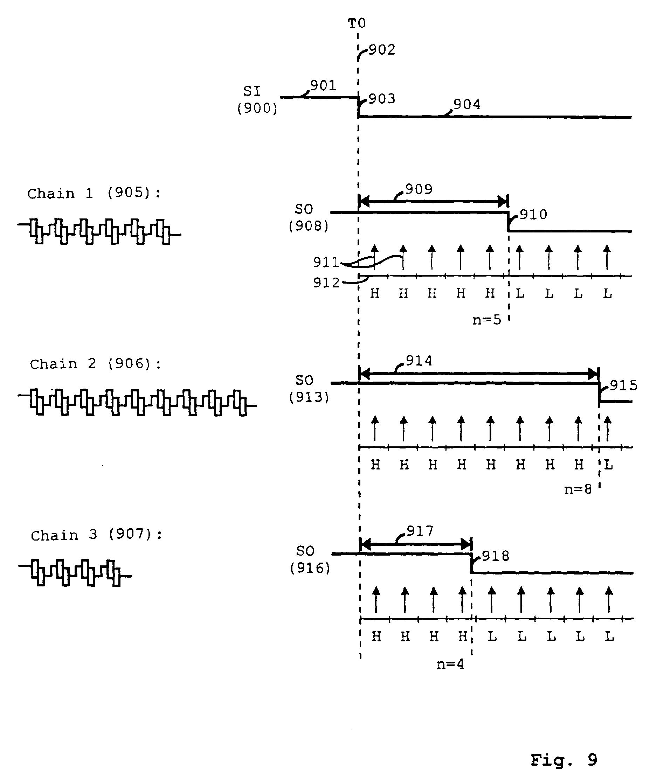

With the measurement method as presented by the invention it is, however, also possible to measure a series of flip-flop chains in parallel. This is shown in Fig. 9. Here the flush delays(0) of three scan paths (905, 906, 907) are to be measured in parallel. For this, after prior initialization with "HIGH" potential (901), an edge (903) from "HIGH" to "LOW" (904) is applied at the time T0 (902) to the respective scan inputs SI (900).

This edge then passes through the flip-flop chains 1 (905), 2 (906) and 3 (907). At the scan output 908 of scan path 1 the edge 910 appears after the relevant flush delay 909. As from the time T0 (902) the scan output of chain 1 is periodically scanned by read pulses 911. The measurements are taken in the middle of the respective measurement interval 912. The first five scans deliver "HIGH" as their result, the following scans deliver "LOW". Thus the result for chain 1 (905) is n = 5. Chain 2 (906) is longer than chain 1 (905), and so the edge 915 also appears at the output 913 of the scan path 2 later than the edge 910 in scan path 1. The flush delay 914 of the scan path 2 is produced as the time gap between the time T0 (902) and the occurrence of the edge 915. In order to determine this flush delay, the scan output 2 (913) must also be periodically scanned by read pulses. Since the measurement at the scan output of chain 2 also begins at the time T0, the measurements are taken synchronously with the measurements on scan path 1. The measuring pulses (strobes) for the various chains (905, 906, 907) can therefore originate from one common clock generator, which may be executed as hardware or software.

In the case of the scan output 913 the first eight read pulses deliver "HIGH", the following ones "LOW". As a result n = 8. Correspondingly, the very short chain 3 (907) only causes a very short flush delay 917 at its scan output 916. Only the first four pulses deliver "HIGH", then the edge 918 occurs and the following pulses deliver "LOW". As a result n = 4.

In the variant of the measurement method as presented by the invention described thus far the measurement accuracy is determined by $\Delta T$. Thus, in order to increase the accuracy $\Delta T$ must be reduced. The read-out rate cannot be increased limitlessly, however; clock rates of more than 200 MHz are only achievable with a high level of design input.

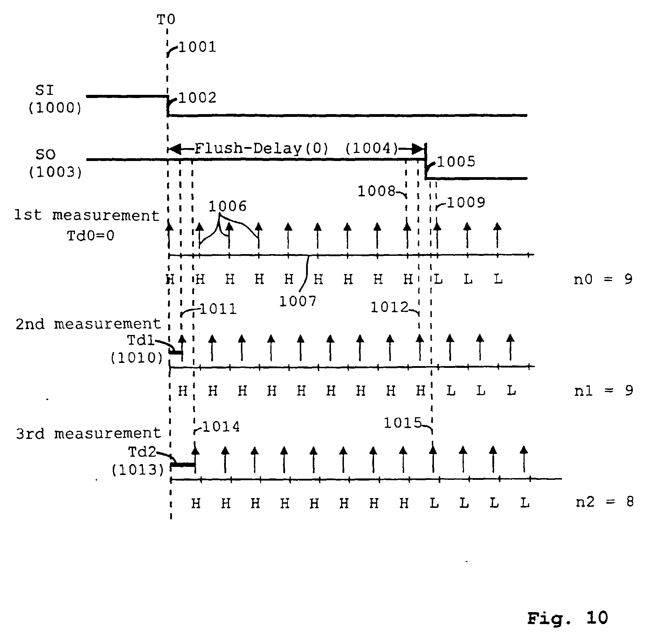

Therefore, to increase accuracy the measurement method described in Fig. 10 is useful. In this, an input potential is applied to the scan input SI (1000) which initializes the scan path being measured at "HIGH" potential. At the time T0 (1001) there is a transition (1002) to "LOW" potential. This edge 1002 propagates through the scan path and appears (1005), delayed by the flush delay(0) (1004), at the output SO (1003) of the scan path.

Then several measurements are taken at the scan output, wherein however the relative time slots of the read-out pulses or strobes (1006) are varied in terms of their measurement interval (1007)

In this, the time span Td is defined as the time gap between the beginning of the measurement interval and the measurement time. For the first measurement Td0 = 0 is selected, meaning that the first measurement is taken right at the beginning of the first measurement interval and thus at the time T0 (1001). 'In this first measurement the first nine strobes deliver a "HIGH" potential. Between the ninth (1008) and tenth (1009) strobes the edge 1005 appears at the scan output. The tenth measurement pulse 1009 is therefore already delivering a "LOW" potential. As a result n0, the number of measurement pulses until the arrival of the edge, is 9.

In the subsequent measurements Td is then increased in steps. In the second measurement the first measurement pulse 1011 is thus not at the time T0 (1001), but shifted away from T0 by Td1 (1010). All subsequent measurement pulses too are shifted by Td1 (1010) in relation to the beginning of their respective measurement interval. The ninth measurement pulse (1012), however, occurs before the edge 1005 arrives at the scan output. Thus for this measurement too n2 = 9.

In our example the value of Td at which the ninth read-out pulse after arrival of the edge 1005 occurs is decisive in determining the flush delay 1004. Formulated in more general terms, the value of Td at which the transition to the next lowest n occurs is decisive. In the example shown, this occurs in the third measurement, at the value Td2 (1013). Here the measurement belonging to the first measurement interval is taken at the time 1014, and the ninth measurement pulse occurs at the time 1015. This ninth measurement pulse occurs after the arrival of the edge 1005 at the scan output. It consequently delivers "LOW" potential as the measurement result. Thus n2 = 8.

The finer the original measurement interval 1007 is scaled, the more measurements must be taken, but the higher is the accuracy achieved. If Td designates the time span in which the transition from the higher to the lower n occurs, the flush delay is produced as:

$$\text{Flush delay} = (n_g - 1) \times \Delta T + Td$$

where $n_g$ here designates the higher n - that is the n before the transition. In the case shown in Fig. 10 this would result in:

$$\text{Flush delay}(0) = 8 \times \Delta T + Td2.$$

**Claims**

1. Method to measure the flush delay of a chain of flip-flops in a chip manufactured in accordance with the LSSD design,
    wherein the flip-flops in the chain are in flush mode,
        characterized by the following steps:

    Initialization of the chain by a first potential applied to the input of the chain.

    Changing of the first potential applied to the input of the chain to a second potential at a start time (T0).

    Repeated read-out of the output of the chain at regular intervals $\Delta T$ as from the start time (T0)

    Calculation of the number n of time intervals $\Delta T$ of which the read-out result has produced the first potential but not yet the second potential.

2. Method in accordance with Claim 1, characterized in that the output of the chain is scanned in the middle of time intervals $\Delta T$.

3. Method in accordance with one of Claims 1 or 2, characterized by the following additional step:

    Calculation of the flush delay as n x $\Delta T$.

4. Method in accordance with one of Claims 1 to 3, characterized by the following additional step:

    Comparison of the scanned potential with a previously defined expected value.

5. Method to measure the flush delay of several chains of flip-flops in a chip manufactured according to LSSD design,
    wherein the flip-flops in the chain are in flush mode,
        characterized by the following steps:

    Initialization of the chain by a first potential applied to the inputs of the chains.

    Synchronous changing of the first potential applied to the inputs of the chains to a second potential at a start time (T0).

    Repeated synchronous read-out of the outputs of the chains at regular intervals $\Delta T$ as from the start time (T0)

    For each chain, calculation of the number n of time intervals $\Delta T$ of which the read-out result has produced the first potential but not yet the second potential.

6. Method in accordance with Claim 5, characterized in that

    the outputs of the chains are scanned in the middle of a time interval $\Delta T$.

7. Method in accordance with one of Claims 5 or 6, characterized by the following additional step:

    Calculation of the flush delay of each chain as n x $\Delta T$.

8. Method in accordance with one of Claims 5 to 7, characterized by the following additional step:

    Comparison of the scanned potentials with previously defined expected values.

9. Tester device to measure the flush delay of a chain of flip-flops in chips manufactured according to LSSD design,
    wherein the flip-flops in the chain are in flush mode,
        characterized by

    means of initializing the chain by a first potential applied to the input of the chain.

    means of changing the first potential applied to the input of the chain to a second potential at a start time (T0)

    means of repeated read-out of the output of the chain at regular intervals $\Delta T$ as from the start time.

means of calculating the number n of time intervals $\Delta T$ of which the read-out result has produced the first potential but not yet the second potential.

10. Tester device to measure the flush delay in accordance with Claim 9, further characterized by

means of calculating the flush delay as n x $\Delta T$.

11. Tester device to measure the flush delay in accordance with one of Claims 9 or 10, further characterized by

means of comparing the scanned potential with a previously defined expected value.

Fig. 1

Fig. 2

Fig. 3

System mode:

Fig. 4A

Scan mode:

Fig. 4B

Fig. 5

Fig. 6

Fig. 7

Fig. 8

T0

SI
(900)

901

902

903

904

Chain 1 (905):

SO
(908)

909

910

911

912

H  H  H  H  H  ¦L  L  L  L

n=5

Chain 2 (906):

SO
(913)

914

915

H  H  H  H  H  H  H  H  ¦L

n=8

Chain 3 (907):

SO
(916)

917

918

H  H  H  H¦  L  L  L  L  L

n=4

Fig. 9

Fig. 10